# EUROPEAN PATENT SPECIFICATION

(11) **EP 4 423 806 B1**
(45) Date of publication and mention of the grant of the patent: **02.12.2026**
(21) Application number: 22888188.4
(22) Date of filing: 27.10.2022
(51) Int. Cl.: H10W 20/00, H10W 72/90, H10W 80/00, H10W 90/00, H10W 72/00

(54) **DIFFUSION BARRIERS FOR BONDING ELEMENTS**
DIFFUSIONSBARRIEREN FÜR VERBINDUNGSELEMENTE
BARRIÈRES DE DIFFUSION POUR ÉLÉMENTS DE CONNEXION

(30) Priority: 28.10.2021 US 202163272891 P
(43) Date of publication of application: 04.09.2024
(73) Proprietor: Adeia Semiconductor Bonding Technologies Inc., San Jose, CA 95134 (US)
(72) Inventor: KATKAR, Rajesh, San Jose, California 95134 (US); UZOH, Cyprian, Emeka, San Jose, California 95134 (US)
(74) Representative: Murgitroyd & Company
(86) International application number: PCT/US2022/048060
(87) International publication number: WO 2023/076495

(56) References cited:
- KR-A- 20160 108 784
- US-A1- 2010 155 951
- US-A1- 2019 088 618
- US-A1- 2019 109 042
- US-A1- 2019 122 931
- US-A1- 2020 294 971
- US-A1- 2021 159 117

## Description

### BACKGROUND

### Field

The field relates to diffusion barriers for contact pads in electronic devices.

### Description of the Related Art

In electronics, metal features, such as copper vias, lines and pads, are often confined by barrier materials intervening between the metal feature and surrounding dielectric material, such as silicon oxide. Without barrier materials, metals like copper can readily diffuse into the dielectric material, especially the dielectric material is a low k materials and risk causing electrical leakage between adjacent metal features or even short circuits between metal features.

Semiconductor elements, such as integrated device dies or chips, may be mounted or stacked on other elements. For example, a semiconductor element can be mounted on a carrier, such as a package substrate, an interposer, a reconstituted wafer or element, etc. As another example, a semiconductor element can be stacked on top of another semiconductor element, *e.g.,* a first integrated device die can be stacked on a second integrated device die. Each of the semiconductor elements can have conductive pads for mechanically and electrically bonding the semiconductor elements to one another. In hybrid bonding, insulating bonding layers of two elements are directly bonded to one another, and conductive contact pads embedded in the insulators are also directly bonded. However, choice of the insulating bonding materials typically involve a trade-off between inhibiting diffusion of metals into the dielectric material and obtaining a strong, low temperature bond.

US2020/294971 discloses a semiconductor device including a first chip that includes a bond pad embedded in a cavity formed in a dielectric bonding layer, the bond pad comprising a diffusion barrier layer on only the sidewalls of the cavity, wherein the diffusion barrier layer comprises a barrier metal including Mn, Ti, Ta or a nitride or oxide of these metals.

There is a continuing need for improved methods for forming the conductive pads for reliable bonding.

### SUMMARY

According to an aspect of the present disclosure, there is provided an element according to claim 1. Further features/aspects according to embodiments of the element are recited in the dependent claims.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures indicates similar or identical items.

For this discussion, the devices and systems illustrated in the figures are shown as having a multiplicity of components.
Figure 1A is a schematic cross-sectional side view of two elements prior to direct hybrid bonding.
Figure 1B is a schematic cross-sectional side view of the two elements shown in Figure 1A after direct hybrid bonding.
Figure 1C is a schematic cross sectional side view of an element.
Figures 2A-2F are schematic cross sectional side views of elements according to various embodiments.
Figures 3A-3G show various steps of a process of manufacturing a bonded structure including elements according to an embodiment.
Figures 4A-4H show various steps of a process of manufacturing a bonded structure including elements according to another embodiment.
Figures 5A-5G show various steps of a process of manufacturing a bonded structure including elements according to other embodiments.
Figure 6 is a schematic cross sectional side view of a bonded structure including elements according to embodiments.
Figure 7 is a schematic cross sectional side view of a bonded structure including elements according to another embodiment.
Figure 8 is a schematic cross sectional side view of a bonded structure including an element according to an embodiment.

### DETAILED DESCRIPTION

The present disclosure describes methods of forming conductive features, such as conductive pads, embedded in dielectric layers. Various embodiments disclosed herein can be advantageous for direct metal bonding, such as direct hybrid bonding. For example, two or more semiconductor elements (such as integrated device dies, wafers, etc.) may be stacked on or bonded to one another to form a bonded structure. Conductive contact pads of one element may be electrically connected to corresponding conductive contact pads of another element. Any suitable number of elements can be stacked in the bonded structure. The methods and bond pad structures described herein can be useful in other contexts as well.

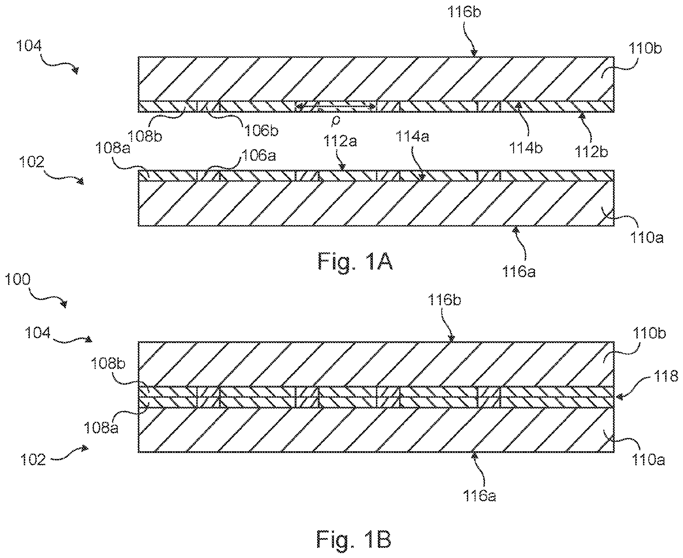

Various embodiments disclosed herein relate to directly bonded structures in which two or more elements can be directly bonded to one another without an intervening adhesive. Figures 1A and 1B schematically illustrate a process for forming a directly hybrid bonded structure without an intervening adhesive according to some embodiments. In Figures 1A and 1B, a bonded structure 100 comprises two elements 102 and 104 that can be directly bonded to one another at a bond interface 118 without an intervening adhesive. Two or more microelectronic elements 102 and 104 (such as semiconductor elements, including, for example, integrated device dies, wafers, passive devices, individual active devices such as power switches, etc.) may be stacked on or bonded to one another to form the bonded structure 100. Conductive features 106a (e.g., contact pads, trenches or traces exposed ends of vias (e.g., TSVs), or a through substrate electrodes) of a first element 102 may be electrically connected to corresponding conductive features 106b of a second element 104. Any suitable number of elements can be stacked in the bonded structure 100. For example, a third element (not shown) can be stacked on the second element 104, a fourth element (not shown) can be stacked on the third element, and so forth. Additionally or alternatively, one or more additional elements (not shown) can be stacked laterally adjacent one another along the first element 102. The laterally stacked additional element may be smaller than the second element. The laterally stacked additional element may be two times smaller than the second element.

The elements 102 and 104 are directly bonded to one another without an adhesive. A non-conductive field region that includes a non-conductive or dielectric material can serve as a first bonding layer 108a of the first element 102 which can be directly bonded to a corresponding non-conductive field region that includes a non-conductive or dielectric material serving as a second bonding layer 108b of the second element 104 without an adhesive. The non-conductive bonding layers 108a and 108b can be disposed on respective front sides 114a and 114b of device portions 110a and 110b, such as a semiconductor (e.g., silicon) portion of the elements 102, 103. Active devices and/or circuitry can be patterned and/or otherwise disposed in or on the device portions 110a and 110b. Active devices and/or circuitry can be disposed at or near the front sides 114a and 114b of the device portions 110a and 110b, and/or at or near opposite backsides 116a and 116b of the device portions 110a and 110b. Bonding layers can be provided on front sides and/or back sides of the elements. The non-conductive material can be referred to as a non-conductive bonding region or bonding layer 108a of the first element 102. The non-conductive bonding layer 108a of the first element 102 can be directly bonded to the corresponding non-conductive bonding layer 108b of the second element 104 using dielectric-to-dielectric bonding techniques. For example, non-conductive or dielectric-to-dielectric bonds may be formed without an adhesive using the direct bonding techniques disclosed at least in U.S. Patent Nos. 9,564,414; 9,391,143; and 10,434,749. It should be appreciated that the bonding layers 108a and/or 108b can comprise a non-conductive material such as a dielectric material, such as silicon oxide, or an undoped semiconductor material, such as undoped silicon. Suitable dielectric bonding surface or materials for direct bonding include but are not limited to inorganic dielectrics, such as silicon oxide, silicon nitride, or silicon oxynitride, or can include carbon, such as silicon carbide, silicon oxycarbonitride, low K dielectric materials, SiCOH dielectrics, silicon carbonitride or diamond-like carbon or a material comprising a diamond surface. Such carbon-containing ceramic materials can be considered inorganic, despite the inclusion of carbon.

The device portions 110a and 110b can have a significantly different coefficients of thermal expansion (CTEs) defining a heterogenous structure. The CTE difference between the device portions 110a and 110b, and particularly between bulk semiconductor, typically single crystal portions of the device portions 110a, 110b, can be greater than 5 ppm or greater than 10 ppm. For example, the CTE difference between the device portions 110a and 110b can be in a range of 5 ppm to 100 ppm, 5 ppm to 40 ppm, 10 ppm to 100 ppm, or 10 ppm to 40 ppm. One of the device portions 110a and 110b can comprise optoelectronic single crystal materials, including perovskite materials, that are useful for optical piezoelectric or pyroelectric applications, and the other of the device portions 110a, 110b comprises a more conventional substrate material. For example, one of the device portions 110a, 110b comprises lithium tantalate (LiTaO3) or lithium niobate (LiNbO3), and the other one of the device portions 110a, 110b comprises silicon (Si), quartz, fused silica glass, sapphire, or a glass. One of the device portions 110a and 110b comprises a III-V single semiconductor material, such as gallium arsenide (GaAs) or gallium nitride (GaN), and the other one of the device portions 110a and 110b can comprise a non-III-V semiconductor material, such as silicon (Si), or can comprise other materials with similar CTE, such as quartz, fused silica glass, sapphire, or a glass.

Direct hybrid bonds can be formed without an intervening adhesive. For example, nonconductive bonding surfaces 112a and 112b can be polished to a high degree of smoothness. The nonconductive bonding surfaces 112a and 112b can be polished using, for example, chemical mechanical polishing (CMP). The roughness of the polished bonding surfaces 112a and 112b can be less than 15 Å rms. For example, the roughness of the bonding surfaces 112a and 112b can be in a range of about 0.1 Å rms to 15 Å rms, 0.5 Å rms to 10 Å rms, or 1 Å rms to 5 Å rms. The bonding surfaces 112a and 112b can be cleaned and exposed to a plasma and/or etchants to activate the surfaces 112a and 112b. The surfaces 112a and 112b can be terminated with a species after activation or during activation (e.g., during the plasma and/or etch processes). Without being limited by theory, the activation process can be performed to break chemical bonds at the bonding surfaces 112a and 112b, and the termination process can provide additional chemical species at the bonding surfaces 112a and 112b that improves the bonding energy during direct bonding. The activation and termination are provided in the same step, e.g., a plasma to activate and terminate the surfaces 112a and 112b. The bonding surfaces 112a and 112b can be terminated in a separate treatment to provide the additional species for direct bonding. The terminating species can comprise nitrogen. For example, the bonding surface(s) 112a, 112b can be exposed to a nitrogen-containing plasma. Further, the bonding surfaces 112a and 112b can be exposed to fluorine. For example, there may be one or multiple fluorine peaks at or near a bond interface 118 between the first and second elements 102, 104. Thus, in the directly bonded structure 100, the bond interface 118 between two non-conductive materials (e.g., the bonding layers 108a and 108b) can comprise a very smooth interface with higher nitrogen content and/or fluorine peaks at the bond interface 118. Additional examples of activation and/or termination treatments may be found throughout U.S. Patent Nos. 9,564,414; 9,391,143; and 10,434,749. The roughness of the polished bonding surfaces 112a and 112b can be slightly rougher (e.g., about 1 Å rms to 30 Å rms, 3 Å rms to 20 Å rms, or possibly rougher) after an activation process.

Conductive features 106a of the first element 102 can also be directly bonded to corresponding conductive features 106b of the second element 104. For example, a direct hybrid bonding technique can be used to provide conductor-to-conductor direct bonds along the bond interface 118 that includes covalently direct bonded non-conductive-to-non-conductive (e.g., dielectric-to-dielectric) surfaces, prepared as described above. The conductor-to-conductor (e.g., conductive feature 106a to conductive feature 106b) direct bonds and the dielectric-to-dielectric hybrid bonds can be formed using the direct bonding techniques disclosed at least in U.S. Patent Nos. 9,716,033 and 9,852,988. In direct hybrid bonding embodiments described herein, conductive features are provided within non-conductive bonding layers, and both conductive and nonconductive features are prepared for direct bonding, such as by the planarization, activation and/or termination treatments described above. Thus, the bonding surface prepared for direct bonding includes both conductive and non-conductive features.

For example, non-conductive (e.g., dielectric) bonding surfaces 112a, 112b (for example, inorganic dielectric surfaces) can be prepared and directly bonded to one another without an intervening adhesive as explained above. Conductive contact features (e.g., conductive features 106a and 106b which may be at least partially surrounded by non-conductive dielectric field regions within the bonding layers 108a, 108b) may also directly bond to one another without an intervening adhesive. The conductive features 106a, 106b can comprise discrete pads or traces at least partially embedded in the non-conductive field regions. The conductive contact features can comprise exposed contact surfaces of through substrate vias (e.g., through silicon vias (TSVs)). The respective conductive features 106a and 106b can be recessed below exterior (e.g., upper) surfaces (non-conductive bonding surfaces 112a and 112b) of the dielectric field region or non-conductive bonding layers 108a and 108b, for example, recessed by less than 30 nm, less than 20 nm, less than 15 nm, or less than 10 nm, for example, recessed in a range of 2 nm to 20 nm, or in a range of 4 nm to 10 nm. Prior to direct bonding, the recesses in the opposing elements can be sized such that the total gap between opposing contact pads is less than 15 nm, or less than 10 nm. The non-conductive bonding layers 108a and 108b can be directly bonded to one another without an adhesive at room temperature and, subsequently, the bonded structure 100 can be annealed. Upon annealing, the conductive features 106a and 106b can expand and contact one another to form a metal-to-metal direct bond. Beneficially, the use of Direct Bond Interconnect, or DBI^{®}, techniques commercially available from Adeia of San Jose, CA, can enable high density of conductive features 106a and 106b to be connected across the direct bond interface 118 (e.g., small or fine pitches for regular arrays). The pitch of the conductive features 106a and 106b, such as conductive traces embedded in the bonding surface of one of the bonded elements, may be less than 100 microns or less than 10 microns or even less than 2 microns. For some applications, the ratio of the pitch of the conductive features 106a and 106b to one of the dimensions (e.g., a diameter) of the bonding pad is less than is less than 20, or less than 10, or less than 5, or less than 3 and sometimes desirably less than 2. In other applications, the width of the conductive traces embedded in the bonding surface of one of the bonded elements may range between 0.3 to 20 microns, e.g., in a range of 0.3 to 3 microns. The conductive features 106a and 106b and/or traces can comprise copper or copper alloys, although other metals may be suitable. For example, the conductive features disclosed herein, such as the conductive features 106a and 106b, can comprise fine-grain metal (e.g., a fine-grain copper).

Thus, in direct bonding processes, a first element 102 can be directly bonded to a second element 104 without an intervening adhesive. In some arrangements, the first element 102 can comprise a singulated element, such as a singulated integrated device die. In other arrangements, the first element 102 can comprise a carrier or substrate (e.g., a wafer) that includes a plurality (e.g., tens, hundreds, or more) of device regions that, when singulated, form a plurality of integrated device dies. Similarly, the second element 104 can comprise a singulated element, such as a singulated integrated device die. In other arrangements, the second element 104 can comprise a carrier or substrate (e.g., a wafer). The embodiments disclosed herein can accordingly apply to wafer-to-wafer (W2W), die-to-die (D2D), or die-to-wafer (D2W) bonding processes. In wafer-to-wafer (W2W) processes, two or more wafers can be directly bonded to one another (e.g., direct hybrid bonded) and singulated using a suitable singulation process. After singulation, side edges of the singulated structure (e.g., the side edges of the two bonded elements) may be substantially flush and may include markings indicative of the common singulation process for the bonded structure (e.g., saw markings if a saw singulation process is used).

As explained herein, the first and second elements 102 and 104 can be directly bonded to one another without an adhesive, which is different from a deposition process and results in a structurally different interface compared to a deposition. In one application, a width of the first element 102 in the bonded structure is similar to a width of the second element 104. A width of the first element 102 in the bonded structure 100 is different from a width of the second element 104. Similarly, the width or area of the larger element in the bonded structure may be at least 10% larger than the width or area of the smaller element. The first and second elements 102 and 104 can accordingly comprise non-deposited elements. Further, directly bonded structures 100, unlike deposited layers, can include a defect region along the bond interface 118 in which nanometer-scale voids (nanovoids) are present. The nanovoids may be formed due to activation of the bonding surfaces 112a and 112b (e.g., exposure to a plasma). As explained above, the bond interface 118 can include concentration of materials from the activation and/or last chemical treatment processes. For example, in embodiments that utilize a nitrogen plasma for activation, a nitrogen peak can be formed at the bond interface 118. The nitrogen peak can be detectable using secondary ion mass spectroscopy (SIMS) techniques. In various embodiments, for example, a nitrogen termination treatment (e.g., exposing the bonding surface to a nitrogen-containing plasma) can replace OH groups of a hydrolyzed (OH-terminated) surface with NH2 molecules, yielding a nitrogen-terminated surface. In embodiments that utilize an oxygen plasma for activation, an oxygen peak can be formed at the bond interface 118. In some embodiments, the bond interface 118 can comprise silicon oxynitride, silicon oxycarbonitride, or silicon carbonitride. As explained herein, the direct bond can comprise a covalent bond, which is stronger than van Der Waals bonds. The bonding layers 108a and 108b can also comprise polished surfaces that are planarized to a high degree of smoothness. The roughness of the polished non-conductive field region can be less than 30 Å rms, and preferably, less than 15 Å rms, less than 10 Å rms, or less than 5 Å rms. For example, the roughness of the polished non-conductive field region 38 can be in a range of 0.1 Å rms to 15 Å rms, 0.1 Å rms to 10 Å rms, 0.1 Å rms to 5 Å rms, 1 Å rms to 10 Å rms, or 1 Å rms to 10 Å rms. The roughness of the polished non-conductive field region can be slightly rougher (e.g., 10 Å rms, 15 Å rms, or 20 Å rms rougher) after an activation process.

The metal-to-metal bonds between the conductive features 106a and 106b can be joined such that metal grains grow into each other across the bond interface 118. The metal can be or include copper, which can have grains oriented along the 111 crystal plane for improved copper diffusion across the bond interface 118. The conductive features 106a and 106b may include nanotwinned copper grain structure, which can aid in merging the conductive features during a higher temperature anneal. The bond interface 118 can extend substantially entirely to at least a portion of the bonded conductive features 106a and 106b, such that there is substantially no gap between the non-conductive bonding layers 108a and 108b at or near the bonded conductive features 106a and 106b. A barrier layer may be provided under and/or laterally surrounding the conductive features 106a and 106b (e.g., which may include copper).

Beneficially, the use of the hybrid bonding techniques described herein can enable extremely fine pitch between adjacent conductive features 106a and 106b, and/or small pad sizes. For example, in various embodiments, the pitch p (i.e., the distance from edge-to-edge or center-to-center, as shown in Figure 1A) between adjacent conductive features 106a (or 106b) can be in a range of 0.5 microns to 50 microns, in a range of 0.75 microns to 25 microns, in a range of 1 micron to 25 microns, in a range of 1 micron to 10 microns, or in a range of 1 micron to 5 microns. Further, a major lateral dimension (e.g., a pad diameter) can be small as well, e.g., in a range of 0.25 microns to 30 microns, in a range of 0.25 microns to 5 microns, or in a range of 0.5 microns to 5 microns.

As described above, the non-conductive bonding layers 108a, 108b can be directly bonded to one another without an adhesive and, subsequently, the bonded structure 100 can be annealed. Upon annealing at a higher temperature, for example between 80°C and 400°C, the conductive features 106a, 106b can expand and contact one another to form a metal-to-metal direct bond. The materials of the conductive features 106a, 106b can interdiffuse during the annealing process.

The metal-to-metal bonds between the contact pads can be joined such that copper grains grow into each other across the bond interface. The copper can have grains oriented vertically along the 111 crystal plane for improved copper diffusion across the bond interface. The misorientation of 111 crystal plane in the conductive material may be in a range of ± 30° with respect to the vertical direction from the surface of the conductive material. The crystal misorientation can be in a range of ± 20°, or in a range of ± 15°, with respect to the vertical direction. The bond interface can extend substantially entirely to at least a portion of the bonded contact pads, such that there is substantially no gap between the nonconductive bonding regions at or near the bonded contact pads. A barrier layer may be provided under the contact pads (e.g., which may include copper).

Annealing temperatures and annealing durations for forming the metal-to-metal direct bond can affect the consumption of thermal budget by the annealing. It may be desirable to lower the annealing temperature and/or annealing duration to minimize consumption of the thermal (energy) budget. Surface diffusion of atoms along the 111 crystal plane (<111>) can be 3 to 4 orders of magnitude faster than along the 100 or 110 crystal planes. Also, a metal (e.g., Cu) with grains oriented along a 111 crystal plane can have a higher surface mobility as compared to conventional back end of line (BEOL) copper. Further, low-temperature direct metal-to-metal bonding is enabled by creep on the 111 plane of nano-twinned Cu of the nano-texture surface. Therefore, it can be advantageous to have the 111 crystal plane on the bonding surface in order to shorten the annealing time and/or reduce the annealing temperature for direct bonding (e.g., direct hybrid bonding). The advantage to have the 111 crystal plane can be pronounced especially at lower temperatures because the metal surface diffusion (e.g., Cu surface diffusion) also slows down when the annealing temperature is reduced. Accordingly, a crystal structure can have grains oriented vertically along the 111 crystal plane to enhance metal diffusion (e.g., copper diffusion) during direct bonding.

A metal layer can be formed with a process selected to plate a copper (Cu) layer having Cu in the 111 crystal orientation. The Cu layer may be deposited from a non-superfilling or super-filling electroplating bath, for example, with plating chemistry selected to optimize efficient filling of voids (e.g., vias, trenches) in the substrate, rather than to optimize the direct metal-to-metal bonding to occur during direct hybrid bonding. Subsequent metal treatment, described hereinbelow, can facilitate subsequent bonding such that any desirable plating chemistry can be employed to optimize for other considerations, such as filling noted above. The microstructure (e.g., a grain size) of the deposited or coated metal layer may be stabilized before a polishing step (e.g., a CMP step), for example by an annealing step, separate from the annealing step of the direct hybrid bonding that occurs later.

An element can include a barrier layer between a contact pad and a dielectric layer. The barrier layer can serve to mitigate or prevent diffusion of the copper into the dielectric layer or neighboring non-conductive material(s). For example, the barrier layer can include materials such as metal layers (e.g., tantalum, titanium, or tungsten) and/or transition metal nitrides (e.g., tungsten nitride, titanium nitride, tantalum nitride, etc.), for example when the barrier layer has a relatively low quality or not-continuous. When the dimensions of the contacts of the contact pad and the pitch between the adjacent pads are relatively small, the thickness of the conductive or non-conductive barrier layers may introduce additional constraints on the pad diameter and pitch.

Embodiments disclosed herein relate to an element, such as a microelectronic element (e.g., an integrated device die, wafer, etc.), that includes a diffusion barrier layer. The diffusion barrier layer can prevent or mitigate diffusion of a material (e.g., a metal) from a conductive feature, such as a contact pad or a through via, into a dielectric layer of the element. The dielectric layer can comprise an inorganic dielectric, such as but not limited to silicon oxide, silicon carbon nitride, and/or silicon oxynitride. As used herein, the term "diffusion barrier layer" refers to either a barrier metal prior to anneal or to a diffused compound material of the barrier metal and the dielectric layer after anneal. In some embodiments, the barrier metal of the diffusion barrier layer can diffuse into the dielectric layer to form the compound material which can act as a redundant barrier layer

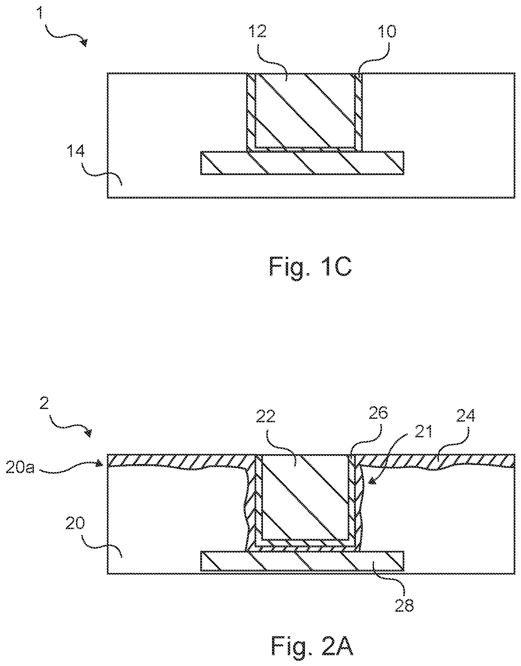

Figure 1C is a schematic cross sectional side view of an element 1 having a metal nitride (e.g., tungsten nitride, tantalum nitride or titanium nitride) layer as a barrier layer 10 between a contact pad 12 and a dielectric layer 14. In Figure 1C, the dielectric layer 14 comprises a silicon oxide based material, and can be referred to more simply as an oxide layer. While the oxide layer has a relatively high bonding strength at low temperature with another oxide layer, it may be susceptible to delamination of conductive materials, particularly copper which adheres poorly to silicon oxide, therethrough, an adhesion layer or barrier layer is needed to strongly couple the conductive pad 12 to the dielectric layer 14. Thus, the disposition of a barrier layer 10, the oxide layer 14, and the conductive pad 12 can enhance the electromigration resistance of the element 1.

Figure 2A is a schematic cross sectional side view of an element 2 according to an embodiment. The element 2 includes a dielectric layer 20 having a cavity 21, a conductive feature 22 at least partially disposed in the cavity 21, and a diffusion barrier layer 24. The dielectric layer 20 can comprise a silicon oxide based material. At least a portion of the diffusion barrier layer 24 is disposed between a portion of the dielectric layer 20 and the conductive feature 22. The portion of the diffusion barrier layer 24 can be conformally disposed along surfaces of the cavity 21. The diffusion barrier layer 24 can also be disposed on an upper surface 20a of the dielectric layer 20. The element 2 can include a more conventional barrier layer 26 (which may include multiple sublayers) and includes a redistribution layer (RDL) 28. The barrier layer 26 can be disposed in the cavity 21 between the conductive feature 22 and the diffusion barrier layer 24. In some embodiments, the redistribution layer 28 can define a bottom surface of the cavity 21. The conductive feature 22 and the redistribution layer 28 can be electrically connected to one another. The barrier metal of the diffusion barrier layer 24 (and possibly of the barrier layer 26) is disposed between the conductive feature 22 and the RDL 28. In some embodiments, the barrier metal of the diffusion barrier layer 24 can form an alloy with a material of the RDL 28 in response to an anneal process.

In some embodiments, the conductive feature 22 can comprise a contact pad, a trench, or a through via (e.g., a through silicon via or a through substrate via). The conductive feature 22 can comprise copper. In some embodiments, the conductive feature 22 can be configured to directly bond to a conductive feature of another element. Thus, it may be subjected to the planarization and activation/termination steps described above, and may be recessed below the upper surface 20a of the dielectric layer 20.

The diffusion barrier layer 24 can be configured to prevent or mitigate diffusion between the conductive feature 22 and the dielectric layer 20. The diffusion barrier layer 24 comprises a barrier metal. In some embodiments, the barrier metal of the diffusion barrier layer 24 can comprise a relatively high oxidation propensity material. The barrier metal of the diffusion barrier layer 24 has an oxidation propensity that is greater than an oxidation propensity of the conductive feature 22. For example, the barrier metal of the diffusion barrier layer 24 can comprise manganese, nickel, titanium, or a metal that has an oxidation propensity generally similar to manganese, nickel, and titanium. In some embodiments, the barrier metal of the diffusion barrier layer 24 can comprise an alloying material that can form an alloy with a material of the conductive feature 22 and or the RDL 28. In some embodiments, the diffusion barrier layer 24 can comprise an elemental metal layer or a metal silicate material.

In some embodiments, somewhat counter-intuitively, the barrier metal of the diffusion barrier layer 24 can diffuse into the dielectric layer 20 when subjected to an anneal. In some embodiments, the barrier metal of the diffusion barrier layer 24 (e.g., Ni, Mn, or Ti) can be diffused into the dielectric layer, thereby defining a diffused metal layer or a barrier compound. For example, when the dielectric layer 20 comprises silicon oxide and the diffusion barrier layer 24 comprises manganese, the diffused metal layer can comprise manganese silicate (MnₓSi_{y}O_{z}), where x, y, and z are numerals. Although additional phases such as manganese oxide (MnO, encompassing particular stoichiometries such as Mn₂O₃ or Mn₃O₄) may be present, the diffused barrier layer may be non-stoichiometric. For example, the diffused barrier layer may comprise laminates of compounds of the metal. The diffused metal layer at the upper surface 20a of the dielectric layer 20 can be polished for direct bonding. The polished surface of the diffused metal layer can be polished to a root-mean-square (rms) surface roughness of less than 2 nm, *e.g.,* less than 1 nm, less than 0.5 nm, etc. In some embodiments, the diffused metal layer can be formed in response to an annealing process. The annealing process can include heating the element 2 at a temperature in a range of, for example, 150°C to 400°C. The diffused metal layer of the diffusion barrier layer 24 can have a gradient of barrier metal concentration tailing away from the barrier layer 26 (when present), the conductive feature 22 or the upper surface 20a of the dielectric layer 20. The diffusion barrier layer 24 can diffuse into the dielectric layer by at least 3 nm. For example, the diffusion barrier layer 24 can diffuse into the dielectric layer in a range of between, for example, 3 nm and 100 nm, 5 nm and 100 nm, 10 nm and 100 nm, 3 nm and 50 nm, 3 nm and 30 nm, or 3 nm and 10 nm. A concentration of the material of the diffusion barrier layer 24 beyond 3 nm can be about 10¹⁷ atoms/cm³. For Example, the concentration of the material of the diffusion barrier layer 24 beyond 3 nm can be in a range of 10¹⁷ atoms/cm³ to about 10¹⁹ atoms/cm³, or about 10¹⁷ atoms/cm³ to about 10¹⁸ atoms/cm³. In some embodiments, the diffused metal layer of the diffusion barrier layer 24 can comprise manganese silicate and/or manganese oxide. The diffused barrier layer may comprise a nonstoichiometric compound of the dielectric layer 20 and the manganese metal, for example.

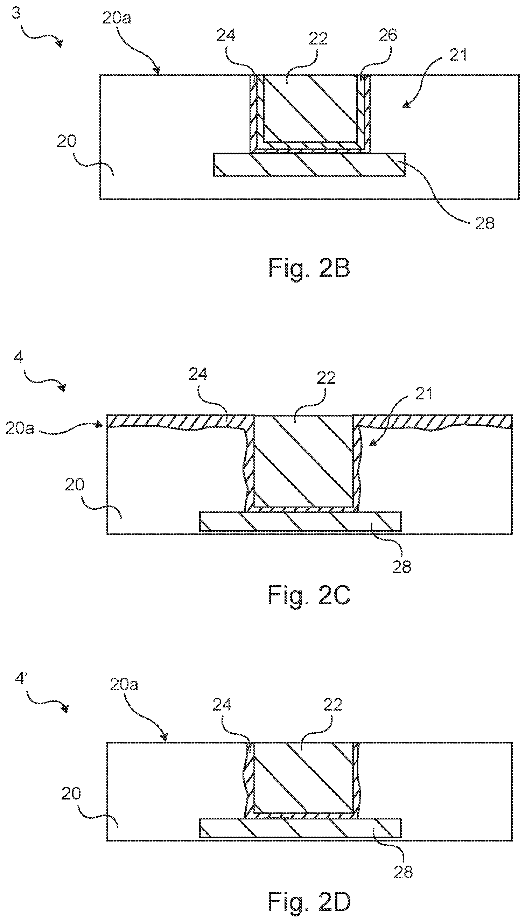

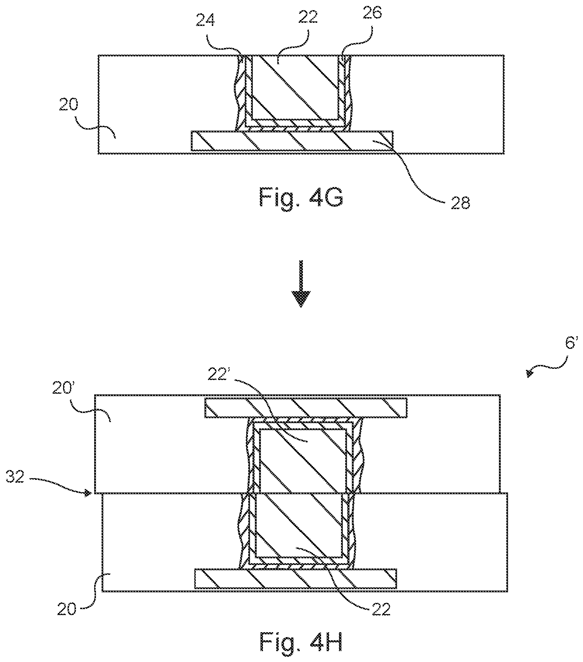

Figure 2B is a schematic cross sectional side view of an element 3 according to an embodiment. The element 3 is generally similar to the element 2 illustrated in Figure 2A except that the diffusion barrier layer 24 in element 3 is disposed only in the cavity 21. In some embodiments, the diffusion barrier layer 24 is not disposed over the upper surface 20a of the dielectric layer 20. In some embodiments, the diffusion barrier layer 24 can be deposited over the upper surface 20a of the dielectric layer 20, and removed completely or partially by one or more of polishing, etching, or other methods. In some embodiments, the intersection between a cavity wall and the upper surface 20a can comprise the diffusion barrier layer 24, but a majority of the upper surface 20a can be free from the diffusion layer 24. The upper surface 20a of the dielectric layer 20 can be polished to a root-mean-square (rms) surface roughness of less than 2 nm, *e.g.,* less than 1 nm, less than 0.5 nm, etc. As will be clear from the description below of Figure 4G, the structure of Figure 2B can result from removal of barrier metal material before anneal, or diffused metal layer after anneal, from over the upper surface 20a of the dielectric layer 20.

Figure 2C is a schematic cross sectional side view of an element 4 according to an embodiment. The element 4 is generally similar to the element 2 illustrated in Figure 2A except that the barrier layer 26 shown in Figure 2A is omitted in the element 4. In some embodiments, the barrier metal of the barrier layer 24 can at least partially form an alloy with a material of the conductive feature 22 and/or RDL 28. Thus, the barrier metal can be detected, as an alloy after anneal, at the interface between the conductive feature 22 and the RDL 28. Therefore, the barrier layer 24 can be present in different forms depending on what the barrier layer 24 abuts. For example, the barrier layer 24 in Figure 2B does not contact the conductive feature 22 and can act as an insulator. On the other hand, the barrier layer 24 in Figure 2C contacts the conductive feature 22 and can form an alloy with the conductive feature 22.

Figure 2D is a schematic cross sectional side view of an element 4' according to an embodiment. The element 4' is generally similar to the element 4 illustrated in Figure 2C except that the diffusion barrier layer 24 of element 4' is disposed only in the cavity 21. Embodiments that omit the barrier layer 26, such as the elements 4, 4', can be especially beneficial when a plurality of conductive features are formed in the dielectric layer 20 with a relatively fine pitch, as the omission of the metal nitride leaves more room in the cavity 21 for the higher conductivity of the conductive feature 22. A diameter of the conductive feature 22 can be under 1 µm.

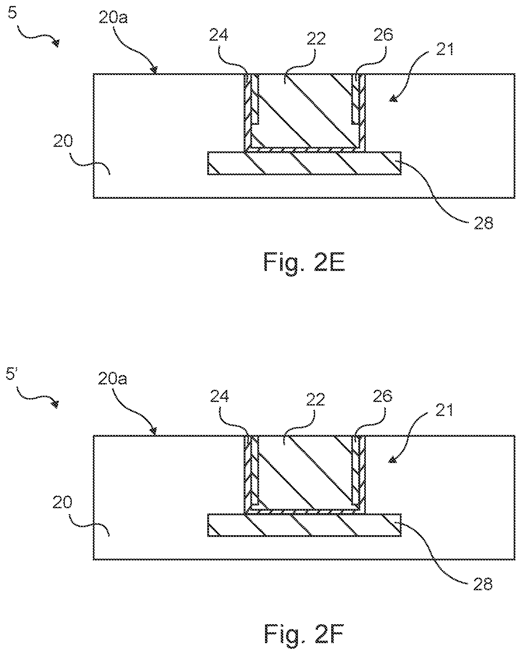

Figure 2E is a schematic cross sectional side view of an element 5 according to an embodiment. The element 5 is generally similar to the element 3 illustrated in Figure 2B except that the barrier layer 26 in element 5 is disposed only partially disposed along sidewalls of the cavity 21. The bottom surface of the cavity 21 can be free from the barrier layer 26, providing better contact resistance between the conductive feature 22 and the RDL 28 than when the barrier layer 26 intervenes the conductive feature 22 and the RDL 28. As noted with respect to Figure 2B, the barrier metal of the barrier layer 24 can form an alloy with a material of the conductive feature 22 and/or RDL 28. Thus, the barrier metal can be detected, as an alloy after anneal, at the interface between the conductive feature 22 and the RDL 28.

Figure 2F is a schematic cross sectional side view of an element 5' according to an embodiment. The element 5' is generally similar to the element 5 illustrated in Figure 2E except that the barrier layer 26 in element 5' extends further down the sidewalls, e.g., covers entire sidewalls of the cavity 21. As with Figure 2E though, the barrier layer 26 is omitted from the bottom of the cavity 21. Embodiments that minimize the barrier layer 26, such as the elements 5, 5', can leave more room in the cavity 21 for the higher conductivity of the conductive feature 22.

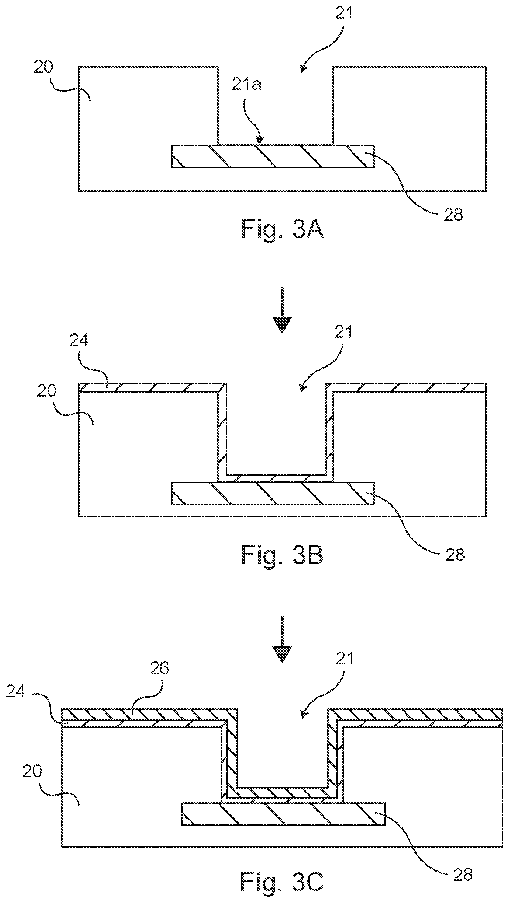

Figures 3A-3G show various steps of a process of manufacturing a bonded structure 6. At Figure 3A, a dielectric layer 20 with a redistribution layer (RDL) 28 is provided, and a cavity 21 is formed (e.g., etched) at least partially through a thickness of the dielectric layer 20. In some embodiments, a portion of the RDL 28 can define a lower surface 21a of the cavity 21. The cavity 21 can extend through an entire thickness of the dielectric layer 20.

At Figure 3B, a diffusion barrier layer 24 is provided over surfaces of the cavity 21 and the upper surface 20a of the dielectric layer 20. At this stage, the diffusion barrier layer 24 is a deposited conductive layer (e.g., barrier metal), and can be an elemental metal layer. In some embodiments, the barrier metal of the diffusion barrier layer 24 can be conformally deposited over the surfaces of the cavity 21 and the upper surface 20a of the dielectric layer 20. The barrier metal of the diffusion barrier layer 24 can comprise manganese, nickel, or titanium. When the barrier metal of the diffusion barrier layer 24 is provided at Figure 3B, the barrier metal can have a barrier metal thickness in a range from 2 nm to 0.3 µm, from 10 nm to 0.15 µm, from 2 nm to 100 nm, or from 10 nm to 100 nm.

At Figure 3C, a barrier layer 26 can be provided over the diffusion barrier layer 24. In some embodiments, the barrier layer 26 can be conformally deposited over the surfaces of the diffusion barrier layer 24. In some embodiments, the barrier layer 26 can comprise a metal and/or metal nitride layer, particular transition metals (e.g., Ta, W), and/or transition metal nitrides (e.g., tungsten nitride, tantalum nitride, and/or titanium nitride layer). In some embodiments the barrier metal of the diffusion layer 24 can comprise a metal nitride layer, transition metal nitride layer, bilayer of tantalum and metal nitride, or a bilayer of tungsten and metal nitride or a metallic compound, such as nickel vanadium alloy for example. The barrier layer 26 can help reduce occurrence of oxide rounding, in some applications. In some embodiments, the barrier layer 26 may serve as a seed layer.

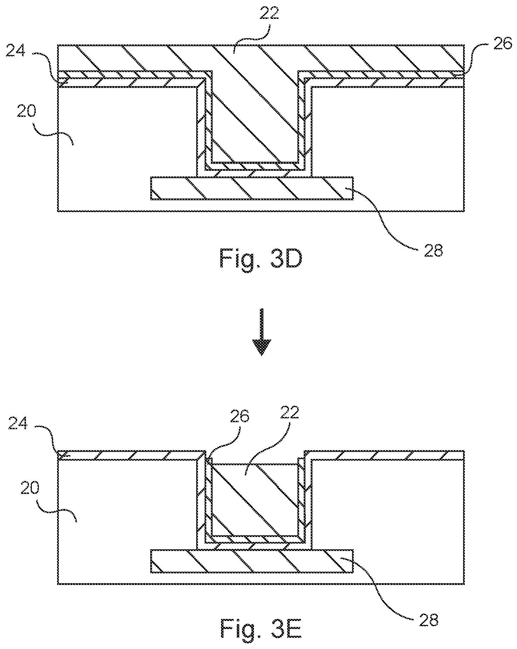

At Figure 3D, a material of a conductive feature 22 is provided over the barrier layer 26 in the cavity 21. The material of the conductive feature 22 can be deposited, and particularly plated, over the barrier layer 26. In some embodiments, the material of the conductive feature 22 can comprise copper.

At Figure 3E, at least a portion of the material of the conductive feature 22 can be removed. The portion of the material of the conductive feature 22 can be removed by way of planarization, such as a chemical-mechanical polishing (CMP) process. At Figure 3E, at least a portion of the barrier layer 26 can also be removed, thereby exposing the diffusion barrier layer 24, which in the illustrated embodiment remains unannealed as a barrier metal layer. The CMP can include multiple phases, where chemistries and/or pads are switched as different materials are revealed. The conductive feature 22 can be polished such that the conductive feature 22 is recessed relative to an upper surface of the diffusion barrier layer 24. At Figure 3E, at least a portion of the barrier metal of the barrier layer 24 may be removed, and the barrier metal thickness of the barrier metal disposed over the surface 20a of the dielectric layer 20 can be in a range from 1 nm to 0.2µm, from 10 nm to 0.1µm, or from 1 nm to 30 nm. In some embodiments, the barrier layer 24 may be discontinuous on the bonding surface of the element.

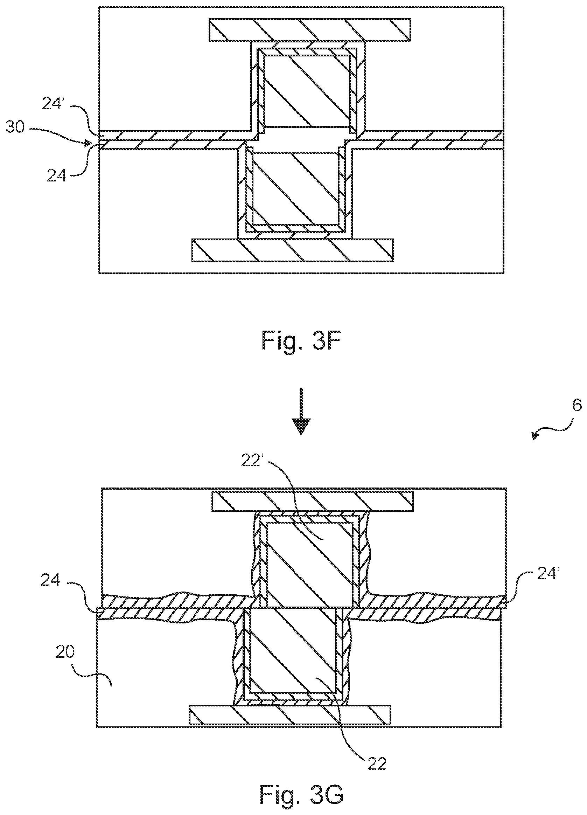

At Figure 3F, another element (e.g., a second element) that has the same or generally similar structure as the structure formed at Figure 3E is provided. The second element can comprise a diffusion barrier layer 24' on a bonding surface of the second element. The diffusion barrier layers 24, 24' (still in the form of unannealed barrier metal) are brought into contact. The diffusion barrier layers 24, 24' can be directly bonded to one another upon contact along a bonding interface 30. In some embodiments, the diffusion barriers 24, 24' can comprise metal (e.g., Mn) and form a metal-to-metal direct bond. In such a metal-to-metal direct bonding, heat may be applied. When the heat is applied, the metal can diffuse into the dielectric layer 20 thereby creating a dielectric bond (e.g., a non-conductive bond interface). The metal-to-metal direct bonding may be achieved without applying an external pressure. In some embodiments, the barrier layer 24 may be disposed only on the bonding surface of the element prior to the bonding operation.

At, Figure 3G, the structure formed in Figure 3F can be annealed to define a bonded contact (bonded conductive features 22, 22') thereby forming the bonded structure 6. In some embodiments, the diffusion barrier layer 24 can diffuse into the dielectric layer 20. In some embodiments, the diffusion barrier layer 24 can diffuse into the conductive feature 22 at the edges of the conductive feature 22. For example, the diffusion barrier layer 24 and the conductive feature 22 can form an alloy. In addition to converting the barrier metal into a diffused metal, forming a compound such as manganese silicate with dielectric layer and having a gradient of barrier metal concentration away from the bonding interface, the anneal also expands the conductive features 22, 22' thereby contacting the conductive features 22, 22' with one another and causing a direct metal-metal bond without an intervening adhesive. The temperature of the heat applied for bonding the diffusion barriers 24, 24' can be lower than the annealing temperature for bonding the conductive features 22, 22'.

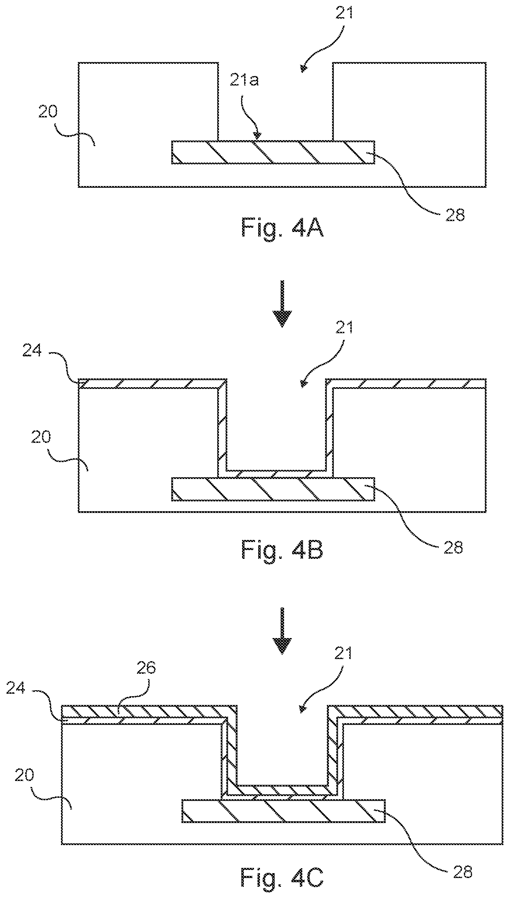

Figures 4A-4H show various steps of a process of manufacturing a bonded structure 6'. At Figure 4A, a dielectric layer 20 with a redistribution layer (RDL) 28 is provided, and a cavity 21 is formed (e.g., etched) at least partially through a thickness of the dielectric layer 20 to expose the underlying RDL 28. In some embodiments, a portion of the RDL 28 can define a lower surface 21a of the cavity 21. The cavity 21 can extend through an entire thickness of the dielectric layer 20.

At Figure 4B, a diffusion barrier layer 24 is provided over surfaces of the cavity 21 and the upper surface 20a of the dielectric layer 20. At this stage the diffusion barrier layer 24 is a deposited metal layer (barrier metal), and can be an elemental metal layer. In some embodiments, the diffusion barrier layer 24 can be conformally deposited over the surfaces of the cavity 21 and the upper surface 20a of the dielectric layer 20. The barrier metal of the diffusion barrier layer 24 can comprise manganese, nickel, or titanium.

At Figure 4C, a barrier layer 26 can be provided over the diffusion barrier layer 24. In some embodiments, the barrier layer 26 can be conformally deposited over the surfaces of the diffusion barrier layer 24. The barrier layer 26 can comprise metal and/or metal nitride layer(s), as described above. In some embodiments, the barrier metal of the diffusion barrier layer 24 can have a diffusivity in the dielectric layer 20 greater than a diffusivity of the metal(s) of the barrier layer 26 in the dielectric layer 20, and can more easily oxidize compared to copper.

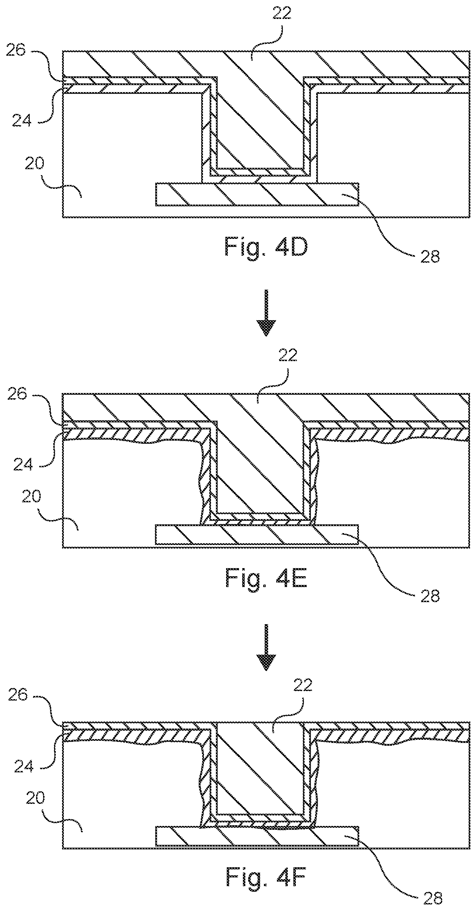

At Figure 4D, a conductive feature 22 is provided over the barrier layer 26. In some embodiments, the conductive feature 22 can be deposited over the barrier layer 26. In some embodiments, the conductive feature can be provided by deposition, and more particularly plating. In some embodiments, the conductive feature 22 can comprise copper.

At Figure 4E, the structure formed in Figure 4D can be annealed. For example, the structure formed in Figure 4D can be annealed at an annealing temperature of about 300 °C, for example, in a range from 150 °C to 300 °C, in a range from 175 °C to 300 °C, in a range from 150 °C to 250 °C, or in a range from 175 °C to 250 °C. The initially metal, diffusion barrier layer 24 can diffuse into the dielectric layer 20 and/or the redistribution layer 28 when the structure is annealed. The anneal can form a compound such as manganese silicate between the materials of the diffusion barrier layer 24 and dielectric layer 20 and a gradient of barrier metal concentration away from an initial interface between the diffusion barrier layer 24 and dielectric layer 20. The anneal need not fully diffuse or compound the barrier metal with the dielectric layer 20, as the structure will be subject to another anneal at Figure 4H for metal-metal direct bonding.

At Figure 4F, at least a portion of the conductive feature 22 can be removed. The portion of the conductive feature 22 can be removed by way of a chemical-mechanical polishing process.

At Figure 4G, the barrier layer 26 and the diffusion barrier layer 24 can be removed. The barrier layer 26 and the diffusion barrier layer 24 can be removed by way of a one or multiple barrier slurries with chemistries for removal of the barrier layer 26 and diffusion barrier layer 24 materials and stopping on the material of the dielectric layer 20.

At Figure 4H, another element (e.g., a second element) that has the same or generally similar structure as the structure formed at Figure 4G is provided, and the two element are brought into contact thereby forming the bonded structure 6'. The surfaces of the dielectric layers 20, 20' can be directly bonded to one another upon contact along a bonding interface 32, forming a strong covalent bond even at room temperature and without pressure. The bonded structure 6' can be annealed after the initial bonding to expand the conductive features 22, 22' and to form a direct hybrid bond (including bonded conductive features 22, 22'), and to strengthen the dielectric-dielectric bond.

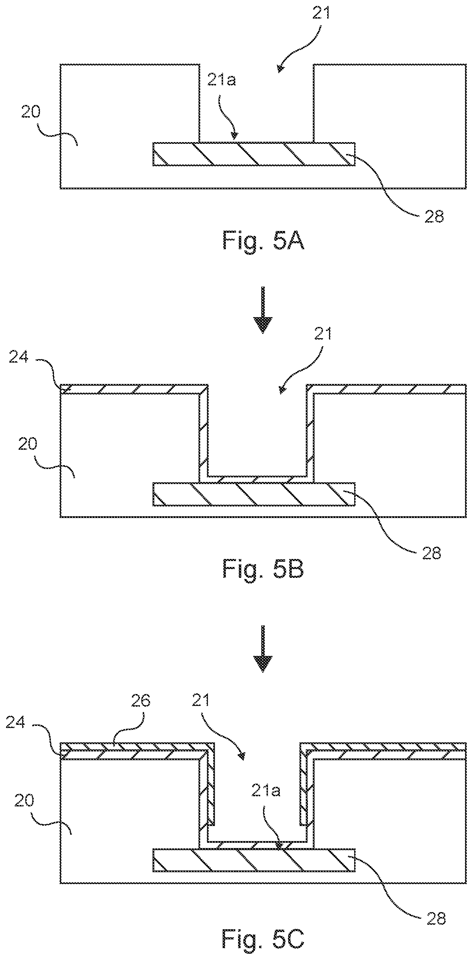

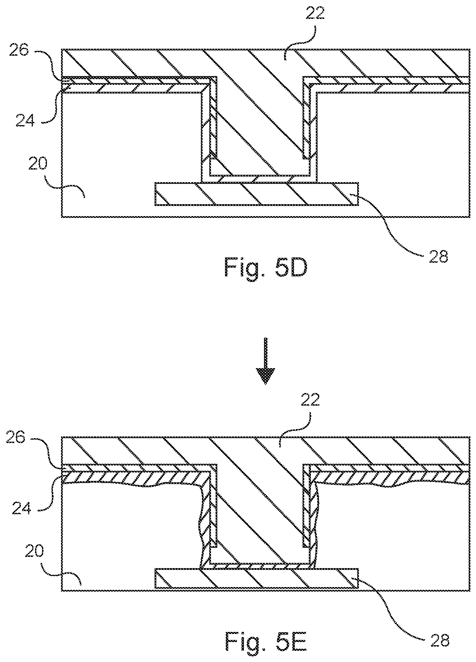

Figures 5A-5G show various steps of a process of manufacturing a bonded structure 7. The process of Figures 5A-5G are generally similar to the process of Figure 4A-4G and some of the differences between the processes are described.

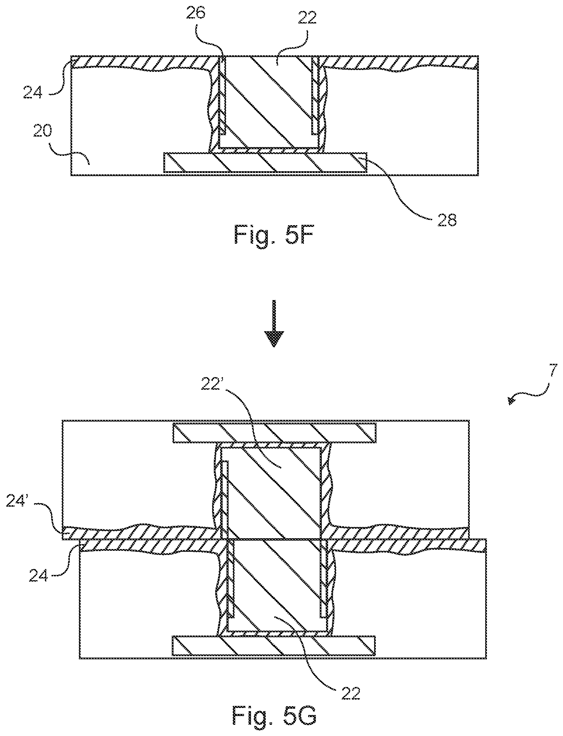

Referring to Figure 5C, the barrier layer 26 is only partially disposed over the diffusion barrier layer 24. In some embodiments, the lower surface 21a of the cavity 21 can be free from the barrier layer 26. As is known in the art, this can be accomplished, for example, by sputtering the barrier layer 26 by non-collimating conditions such that the barrier layer coats the side wall of the cavity without coating the lower portion or the lower surface 21a or only partially coating (e.g., discontinuously coating) the lower surface 21a. In some embodiments, at least a lower portion of sidewalls of the cavity 21 can be free from the barrier layer 26. As in Figure 4E, the diffusion barrier layer 24 can be diffused by a short and/or low temperature anneal at this stage. The anneal can form a compound such as manganese silicate with dielectric layer and having a gradient of barrier metal concentration away from the interface between the dielectric layer 20 and the diffusion barrier layer 24. The anneal need not fully diffuse or compound the barrier metal with the dielectric layer 20, as the structure will be subject to another anneal at Figure 5G for metal-metal direct bonding.

In some embodiments, the barrier layer 26 can be discontinuously disposed and directly in contact with the sidewalls of the cavity 21. The diffused barrier layer 24 can be coated on the barrier layer 26, and be disposed between the barrier layer 26 and the conductive feature 22 (see Figure 5D). Within the dielectric cavity 21, a first portion of the diffused barrier layer 24 can be in contact with portions of the barrier layer 26 and a second portion of the diffused barrier layer 24 can be in contact with a surface of the dielectric layer 20 and the lower surface 21a of the of the cavity 21 or a top surface of the redistribution layer 28. Still in some other embodiments (not shown), the barrier layer 26 can contact the sidewalls of the cavity 21 and the diffused barrier layer 24 can contact the lower surface 21a of the cavity 21.

At Figure 5F, at least a portion of the conductive feature 22 and a remaining portion of the barrier layer 26 can be removed from the upper surface of the dielectric layer 20. The portion of the conductive feature 22 and the portion of the barrier layer 26 can be removed by way of planarization, such as a chemical-mechanical polishing (CMP) process. The diffusion barrier layers 24, 24' can be partially or completely removed by way of planarization, such as a chemical-mechanical polishing (CMP) process.

At Figure 5G, the diffusion barrier layers 24, 24' are bonded to one another. As discussed with respect to FIG. 4H, the dielectric layers 20, 20' including diffused diffusion barrier layers 24, 24' can be directly covalently bonded to one another at room temperature without pressure. The bonded structure 7 can then be annealed to expand and bond the conductive features 22, 22', while strengthening the dielectric direct bond and increasing diffusion and compounding of the barrier metal to form dielectric compounds, such as manganese silicate and manganese oxide.

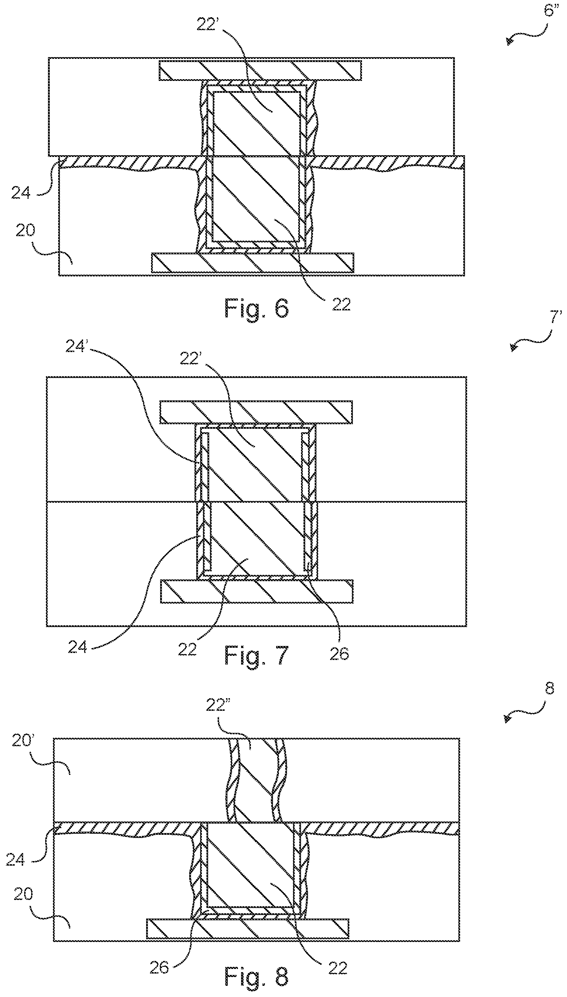

Figures 6-8 illustrate various embodiments of bonded structures, wherein one or both elements of the directly hybrid bonded structures include diffusion barrier layers as described herein.

Figure 6 is a schematic cross sectional side view of a bonded structure 6". The bonded structure 6" can include the elements of Figures 3E and 4G. Figure 7 is a schematic cross sectional side view of a bonded structure 7'. The bonded structure 7' can be generally similar to the bonded structure 7 illustrate in Figure 5G, except in the bonded structure 7', the diffusion barrier layers 24, 24' are omitted from the bonding interface between the elements being bonded. Figure 8 is a schematic cross sectional side view of a bonded structure 8. As shown in Figure 8, the bonded structure 8 includes an element having a conductive feature 22 (e.g., a conductive pad) that is bonded to an element having a conductive feature 22" (e.g., a through via). The through via can comprise a through silicon via (TSV) that at least partially extend through a thickness of a dielectric layer 20'.

In one aspect, an element is disclosed. The element includes a dielectric bonding layer having a cavity that extends at least partially through a thickness of the dielectric bonding layer from a surface of the dielectric bonding layer. The element includes a conductive feature that is at least partially disposed in the cavity. The conductive feature has a contact surface. The element includes a diffusion barrier layer between the conductive feature and a portion of the dielectric bonding layer. The diffusion barrier layer includes a barrier metal. The barrier metal of the diffusion barrier layer has an oxidation propensity that is greater than an oxidation propensity of the conductive feature.

The element further includes a redistribution layer (RDL) below a bottom surface of the conductive feature opposite the contact surface. The barrier metal is disposed between the conductive feature and the RDL.

In one embodiment, the barrier metal has a diffusivity with the dielectric bonding layer greater than a diffusivity of tantalum or tantalum nitride with the dielectric layer.

In one embodiment, a thickness of the barrier metal is in a range from 2 nm to 50 nm.

In one embodiment, a thickness of the barrier metal is in a range from 1 nm to 100 nm.

In one embodiment, the surface of the dielectric bonding layer includes a bonding surface that is configured to directly bond to a dielectric layer of another element. The contact surface of the conductive feature can be configured to directly bond to a contact pad of the other element.

In one embodiment, the conductive feature includes copper.

In one embodiment, the diffusion barrier layer includes a material that diffuses into the dielectric layer in response to an annealing process.

In one embodiment, the dielectric bonding layer includes silicon oxide. The diffusion barrier layer can include a barrier compound including the barrier metal and material of the dielectric bonding layer. The barrier compound can include manganese silicate or a manganese compound.

In one embodiment, a portion of the diffusion barrier layer is further disposed on the surface of the dielectric bonding layer, the portion of the diffusion barrier layer is configured to bond to a dielectric layer of another element.

In one embodiment, the element further includes a barrier layer at least partially between the diffusion barrier layer and the conductive feature. The barrier layer can be not disposed on a bottom surface of the cavity. The barrier layer can be disposed partially along sidewalls of the cavity from the surface of the dielectric bonding layer. The barrier layer can be disposed such that the barrier layer completely separates the conductive feature and the diffusion barrier layer. The barrier layer can include tungsten nitride, tantalum nitride and/or titanium nitride.

In one embodiment, the barrier metal is configured to form an alloy with the conductive feature.

In one embodiment, the contact surface of the conductive feature is free from the barrier metal.

In one embodiment, the conductive feature is a through substrate via. The through substrate via can extend through the thickness of the dielectric layer.

In one embodiment, the diffusion barrier layer includes an elemental metal layer of the barrier metal, and the element is unbonded.

In one embodiment, the diffusion barrier layer includes a metal silicate material including the barrier metal, and the element is hybrid direct bonded to a second element.

In one embodiment, the barrier metal includes manganese.

In one embodiment, the barrier metal includes nickel.

The following is a list of aspects and embodiments outside the scope of the invention as claimed:

In one aspect, an element having a direct hybrid bonding surface is disclosed. The element includes a dielectric bonding layer having a cavity that extends at least partially through a thickness of the dielectric bonding layer from a surface of the dielectric bonding layer. The element includes a conductive feature that is at least partially disposed in the cavity. The conductive feature has a contact surface. The element includes a diffusion barrier layer between the conductive feature and a portion of the dielectric bonding layer. The contact surface of the conductive feature defines a portion of the direct hybrid bonding surface.

In one embodiment, the diffusion barrier layer includes a diffused metal layer having a gradient of manganese concentration.

In one embodiment, the surface of the dielectric bonding layer includes a bonding surface that is configured to directly bond to a dielectric layer of another element. The contact surface of the conductive feature can be configured to directly bond to a contact pad of the other element.

In one embodiment, the conductive feature includes copper.

In one embodiment, the dielectric bonding layer includes silicon oxide. The diffusion barrier layer can include manganese silicate or manganese oxide and the element is directly hybrid bonded to a second element. A portion of the diffusion barrier layer can be further disposed on the surface of the dielectric bonding layer at a bonding interface with the second element.

In one embodiment, the element further includes a barrier layer at least partially between the diffusion barrier layer and the conductive feature. The barrier layer can be not disposed on a bottom surface of the cavity. The barrier layer can be disposed partially along sidewalls of the cavity from the surface of the dielectric bonding layer. The barrier layer can be disposed such that the barrier layer completely separates the conductive feature and the diffusion barrier layer. The barrier layer can include a metal nitride layer.

The element further includes a redistribution layer (RDL) below a bottom surface of the conductive feature opposite the contact surface. The element can be unbonded.

In one aspect, a bonded structure is disclosed. The bonded structure includes a first element. The first element includes a dielectric bonding layer having a cavity that extends at least partially through a thickness of the dielectric bonding layer from a surface of the dielectric bonding layer, a conductive feature that is at least partially disposed in the cavity, and a diffusion barrier layer between the conductive feature and a portion of the dielectric bonding layer. The conductive feature has a contact surface. The diffusion barrier layer can include a barrier metal diffused into and compounded with the dielectric bonding layer. The bonded structure includes a second element. The second element can include a second dielectric layer that is directly bonded to the dielectric bonding layer of the first element, and a second conductive feature that is directly bonded to the contact surface of the conductive feature of the first element without an intervening adhesive.

In one embodiment, the dielectric bonding layer of the first element is directly bonded to the second dielectric layer of the second element.

In one embodiment, the conductive feature and the second conductive feature include copper.

In one embodiment, the barrier metal includes manganese. The dielectric bonding layer can include silicon oxide. The diffusion barrier layer can include manganese silicate or a manganese compound.

In one embodiment, the barrier metal includes nickel.

In one embodiment, the bonded structure further includes a barrier layer at least partially between the diffusion barrier layer and the conductive feature. The barrier layer can be not disposed on a bottom surface of the cavity. The barrier layer can be disposed partially along sidewalls of the cavity from the surface of the dielectric bonding layer. The barrier layer can be disposed such that the barrier layer completely separates the conductive feature and the diffusion barrier layer. The barrier layer can include a metal nitride.

The bonded structure further includes a redistribution layer (RDL) below a bottom surface of the conductive feature opposite the contact surface. The barrier metal is present at an interface between the conductive feature and the RDL.

In one embodiment, the barrier metal and the conductive feature form an alloy.

In one aspect, a bonded structure is disclosed. The bonded structure includes a first element. The first element includes a dielectric bonding layer having a cavity that extends at least partially through a thickness of the dielectric bonding layer from a surface of the dielectric bonding layer, a conductive feature that is at least partially disposed in the cavity, and a diffusion barrier layer between the conductive feature and a portion of the dielectric bonding layer. The conductive feature has a contact surface. The diffusion barrier layer includes manganese. The bonded structure includes a second element. The second element includes a second dielectric layer that is bonded to the dielectric bonding layer of the first element, and a second conductive feature that is directly bonded to the contact surface of the conductive feature of the first element without an intervening adhesive.

In one embodiment, the dielectric bonding layer of the first element is directly bonded to the second dielectric layer of the second element.

In one embodiment, the conductive feature includes copper.

In one embodiment, the dielectric bonding layer includes silicon oxide. The diffusion barrier layer can include manganese silicate or a manganese compound. The bonded structure can further include a barrier layer at least partially between the diffusion barrier layer and the conductive feature. The barrier layer can be not disposed on a bottom surface of the cavity. The barrier layer can be disposed partially along sidewalls of the cavity from the surface of the dielectric bonding layer. The barrier layer can be disposed such that the barrier layer completely separates the conductive feature and the diffusion barrier layer. The barrier layer can include a metal nitride.

The bonded structure further includes a redistribution layer (RDL) below a bottom surface of the conductive feature opposite the contact surface. Manganese can be present at an interface between the conductive feature and the RDL.

In one embodiment, the manganese and the conductive feature form an alloy.

In one aspect, a method of forming an element is disclosed. The method can include providing a barrier metal layer on surfaces of a cavity formed in a dielectric layer. The barrier metal layer includes a barrier metal that is configured to diffuse into the dielectric layer. The cavity at least partially extends through a thickness of the dielectric layer from an upper surface of the dielectric layer. The method can include providing a conductive feature in the cavity over the barrier metal layer. The method can include preparing a surface of the element for direct bonding. A diffusivity of the barrier metal in the dielectric layer by at least 3 nm.

The providing the barrier metal layer can include conformably providing the barrier metal layer on the surfaces of the cavity.

The barrier metal can have an oxidation propensity that is greater than an oxidation propensity of the conductive feature.

Providing the barrier metal layer can include providing the barrier metal layer to have a barrier metal thickness of 5nm to 100nm.

Providing the barrier metal layer can include providing the barrier metal layer to have a barrier metal thickness of 1nm to 100nm.

The method can further include annealing the element to diffuse the barrier metal into the dielectric layer and form a barrier diffusion layer. The annealing can include annealing at a temperature between 150 °C to 400 °C. The annealing can include annealing at a temperature between 150 °C to 350 °C.

Providing the barrier metal layer can include depositing an elemental metal layer of the barrier metal.

Providing the barrier metal layer can include providing the barrier metal layer on the upper surface of the dielectric layer.

The method can further include lining the cavity with a barrier layer after providing the barrier metal layer and before providing the conductive feature. The barrier layer can be disposed such that the barrier layer completely separates the conductive feature and the barrier metal layer. The barrier layer can include a metal nitride.

The method can further include forming an alloy between the conductive feature and the barrier metal along sidewall of the conductive feature.

The method can further include removing at least a portion of the conductive feature by chemical-mechanical polishing. The method can further include removing the diffusion barrier layer from the upper surface of the dielectric layer. The method can further include recessing the conductive feature below the upper surface of the dielectric layer in preparation for direct hybrid bonding.

The method can include no deposition of the barrier metal on the conductive feature.

In one aspect, A method of forming a bonded structure includes bonding the element to another element, and annealing the element and the other element. The annealing can cause the barrier metal to diffuse into and compound with the dielectric layer to form a diffusion barrier layer. The annealing can cause the barrier metal and the conductive feature to form an alloy.

In one aspect, a method of forming an element is disclosed. The method can include providing a manganese layer on surfaces of a cavity formed in a dielectric layer. The cavity at least partially extends through a thickness of the dielectric layer from an upper surface of the dielectric layer. The method can include providing a conductive feature in the cavity over the manganese layer and preparing a surface of the element for direct bonding.

The method can further include annealing the manganese layer to form a manganese silicate or a manganese compound. The annealing forms a copper-manganese alloy along sidewalls of the conductive feature. The annealing includes annealing at a temperature between 150 °C to 250 °C.

Providing the manganese layer can include depositing elemental manganese.

Providing the manganese layer can include providing the manganese layer on the upper surface of the dielectric layer.

The method can further include depositing a barrier layer after providing the manganese layer and before providing the conductive feature. The barrier layer can be disposed such that the barrier layer completely separates the conductive feature and the manganese layer. The barrier layer can be a metal nitride.

The method can further include removing at least the portion of the conductive feature by chemical-mechanical polishing. The method can further include removing the manganese layer from the upper surface of the dielectric layer. The method can further include recessing the conductive feature below the upper surface of the dielectric layer.

In one aspect, a method of forming a bonded structure includes bonding the element to another element, and annealing the element and the other element. The annealing can cause manganese from the manganese layer to diffuse into the dielectric layer. The annealing can cause the manganese layer and the conductive feature to form an alloy.

In one aspect, a method of forming a bonded structure is disclosed. The method can include providing a first element that includes a dielectric bonding layer having a cavity that extends at least partially through a thickness of the dielectric bonding layer from a surface of the dielectric bonding layer, a conductive feature that is at least partially disposed in the cavity, and a diffusion barrier layer that includes a barrier metal between the conductive feature and a portion of the dielectric bonding layer. The conductive feature has a contact surface. A diffusivity of the barrier metal of the diffusion barrier layer with the dielectric bonding layer is at least 5nm. The method can include providing a second element comprising a second dielectric bonding layer, and a second conductive feature, directly bonding the dielectric bonding layer of the first element to the second dielectric bonding layer of the second element, and directly bonding the contact surface of the conductive feature of the first element to the second conductive feature of the second element without an intervening adhesive.

The method can further include annealing the bonded structure thereby diffusing the barrier metal into the dielectric bonding layer to form the diffusion barrier layer. The annealing can cause the directly bonding the contact surface of the conductive feature and the second conductive feature comprises annealing at a temperature between 150 °C to 250 °C.

The first element can further include a barrier layer between the conductive feature and the diffusion barrier layer. The barrier layer can be disposed such that the barrier layer completely separates the conductive feature and the diffusion barrier layer. The barrier layer can include a metal nitride.

Unless the context clearly requires otherwise, throughout the description and the claims, the words "comprise," "comprising," "include," "including" and the like are to be construed in an inclusive sense, as opposed to an exclusive or exhaustive sense; that is to say, in the sense of "including, but not limited to." The word "coupled", as generally used herein, refers to two or more elements that may be either directly connected, or connected by way of one or more intermediate elements. Likewise, the word "connected", as generally used herein, refers to two or more elements that may be either directly connected, or connected by way of one or more intermediate elements. Additionally, the words "herein," "above," "below," and words of similar import, when used in this application, shall refer to this application as a whole and not to any particular portions of this application. Moreover, as used herein, when a first element is described as being "on" or "over" a second element, the first element may be directly on or over the second element, such that the first and second elements directly contact, or the first element may be indirectly on or over the second element such that one or more elements intervene between the first and second elements. Where the context permits, words in the above Detailed Description using the singular or plural number may also include the plural or singular number respectively. The word "or" in reference to a list of two or more items, that word covers all of the following interpretations of the word: any of the items in the list, all of the items in the list, and any combination of the items in the list.

## Claims

1. An element (2, 3, 4, 4', 5, 5') comprising:
a dielectric bonding layer (20) having a cavity (21) extending at least partially through a thickness of the dielectric bonding layer from a surface (20a) of the dielectric bonding layer;
a conductive feature (22) at least partially disposed in the cavity, the conductive feature having a contact surface;
a redistribution layer, RDL, (28) below a bottom surface of the conductive feature (22) opposite the contact surface; and
a diffusion barrier layer (24) disposed between the conductive feature (22) and at least a portion of the dielectric bonding layer (20) and between the conductive feature (22) and the RDL (28), the diffusion barrier layer (24) comprising a barrier metal,
wherein the barrier metal of the diffusion barrier layer (24) has an oxidation propensity that is greater than an oxidation propensity of the conductive feature (22).

2. The element of Claim 1, wherein the barrier metal has a diffusivity with the dielectric bonding layer (20) greater than a diffusivity of tantalum or tantalum nitride with the dielectric bonding layer (20).

3. The element of Claim 1, wherein a thickness of the barrier metal is in a range from 1 nm to 100 nm.

4. The element of Claim 1, wherein the surface (20a) of the dielectric bonding layer (20) comprises a bonding surface (32) that is configured to directly bond to a dielectric layer (20') of another element, and the contact surface of the conductive feature (22) is configured to directly bond to a contact pad (22') of the other element.

5. The element of Claim 1, wherein the diffusion barrier layer (24) comprises a material that diffuses into the dielectric bonding layer (20) in response to an annealing process.

6. The element of Claim 1, wherein the dielectric bonding layer (20) comprises silicon oxide, the diffusion barrier layer (24) comprises a barrier compound including the barrier metal and material of the dielectric bonding layer (20), and the barrier compound comprises manganese silicate or a manganese compound.

7. The element of Claim 1, wherein a portion of the diffusion barrier layer (24) is further disposed on the surface (20a) of the dielectric bonding layer (20), and the portion of the diffusion barrier layer (24) is configured to bond to a dielectric layer (20') of another element.

8. The element (2, 3, 5, 5') of Claim 1, further comprising a barrier layer (26) at least partially between the diffusion barrier layer (24) and the conductive feature (22).

9. The element (5, 5') of Claim 8, wherein the barrier layer (26) is not disposed on a bottom surface of the cavity (21), and the barrier layer (26) is disposed partially along sidewalls of the cavity (21) from the surface (20a) of the dielectric bonding layer (20).

10. The element (2, 3) of Claim 8, wherein the barrier layer (26) is disposed such that the barrier layer completely separates the conductive feature (22) and the diffusion barrier layer (24).

11. The element of Claim 8, wherein the barrier layer (26) comprises tungsten nitride, tantalum nitride or titanium nitride.

12. The element of Claim 1, wherein the barrier metal is configured to form an alloy with the conductive feature (22).

13. The element of Claim 1, wherein the diffusion barrier layer (24) comprises a metal silicate material including the barrier metal, and the element is configured to be hybrid direct bonded to a second element.

14. The element of any of the preceding claims, wherein the barrier metal comprises manganese, nickel, or titanium.

## Patentansprüche

1. Ein Element (2, 3, 4, 4', 5, 5'), das Folgendes beinhaltet:
eine dielektrische Bondingschicht (20), die eine Ausnehmung (21) aufweist, die sich ausgehend von einer Oberfläche (20a) der dielektrischen Bondingschicht mindestens teilweise durch eine Dicke der dielektrischen Bondingschicht erstreckt;
ein leitfähiges Merkmal (22), das mindestens teilweise in der Ausnehmung angeordnet ist, wobei das leitfähige Merkmal eine Kontaktoberfläche aufweist;
eine Umverteilungsschicht, RDL, (28) unter einer der Kontaktoberfläche gegenüberliegenden unteren Oberfläche des leitfähigen Merkmals (22); und
eine Diffusionsbarriereschicht (24), die zwischen dem leitfähigen Merkmal (22) und mindestens einem Abschnitt der dielektrischen Bondingschicht (20) und zwischen dem leitfähigen Merkmal (22) und der RDL (28) angeordnet ist, wobei die Diffusionsbarriereschicht (24) ein Barrieremetall beinhaltet,
wobei das Barrieremetall der Diffusionsbarriereschicht (24) eine Oxidationsneigung aufweist, die größer als eine Oxidationsneigung des leitfähigen Merkmals (22) ist.

2. Element gemäß Anspruch 1, wobei das Barrieremetall eine Diffusivität mit der dielektrischen Bondingschicht (20) aufweist, die größer als eine Diffusivität von Tantal oder Tantalnitrid mit der dielektrischen Bondingschicht (20) ist.

3. Element gemäß Anspruch 1, wobei eine Dicke des Barrieremetalls in einem Bereich von 1 nm bis 100 nm liegt.

4. Element gemäß Anspruch 1, wobei die Oberfläche (20a) der dielektrischen Bondingschicht (20) eine Bondingoberfläche (32) beinhaltet, die konfiguriert ist, um direkt an eine dielektrische Schicht (20') eines anderen Elements zu bonden, und die Kontaktoberfläche des leitfähigen Merkmals (22) konfiguriert ist, um direkt an ein Kontaktpad (22') des anderen Elements zu bonden.

5. Element gemäß Anspruch 1, wobei die Diffusionsbarriereschicht (24) ein Material beinhaltet, das als Reaktion auf einen Temperprozess in die dielektrische Bondingschicht (20) diffundiert.

6. Element gemäß Anspruch 1, wobei die dielektrische Bondingschicht (20) Siliciumoxid beinhaltet, die Diffusionsbarriereschicht (24) eine Barriereverbindung beinhaltet, die das Barrieremetall und Material der dielektrischen Bondingschicht (20) umfasst, und die Barriereverbindung Mangansilicat oder eine Manganverbindung beinhaltet.

7. Element gemäß Anspruch 1, wobei ein Abschnitt der Diffusionsbarriereschicht (24) ferner auf der Oberfläche (20a) der dielektrischen Bondingschicht (20) angeordnet ist und der Abschnitt der Diffusionsbarriereschicht (24) konfiguriert ist, um an eine dielektrische Schicht (20') eines anderen Elements zu bonden.

8. Element (2, 3, 5, 5') gemäß Anspruch 1, das ferner eine Barriereschicht (26) mindestens teilweise zwischen der Diffusionsbarriereschicht (24) und dem leitfähigen Merkmal (22) beinhaltet.

9. Element (5, 5') gemäß Anspruch 8, wobei die Barriereschicht (26) nicht auf einer unteren Oberfläche der Ausnehmung (21) angeordnet ist und die Barriereschicht (26) teilweise entlang von Seitenwänden der Ausnehmung (21) ausgehend von der Oberfläche (20a) der dielektrischen Bondingschicht (20) angeordnet ist.

10. Element (2, 3) gemäß Anspruch 8, wobei die Barriereschicht (26) so angeordnet ist, dass die Barriereschicht das leitfähige Merkmal (22) und die Diffusionsbarriereschicht (24) vollständig trennt.

11. Element gemäß Anspruch 8, wobei die Barriereschicht (26) Wolframnitrid, Tantalnitrid oder Titannitrid beinhaltet.

12. Element gemäß Anspruch 1, wobei das Barrieremetall konfiguriert ist, um eine Legierung mit dem leitfähigen Merkmal (22) zu bilden.

13. Element gemäß Anspruch 1, wobei die Diffusionsbarriereschicht (24) ein Metallsilicatmaterial beinhaltet, das das Barrieremetall umfasst, und das Element konfiguriert ist, um hybrid direkt an ein zweites Element gebondet zu werden.

14. Element gemäß einem der vorhergehenden Ansprüche, wobei das Barrieremetall Mangan, Nickel oder Titan beinhaltet.

## Revendications

1. Un élément (2, 3, 4, 4', 5, 5') comprenant :
une couche de liaison diélectrique (20) ayant une cavité (21) s'étendant au moins partiellement à travers une épaisseur de la couche de liaison diélectrique depuis une surface (20a) de la couche de liaison diélectrique ;
un organe conducteur (22) disposé au moins partiellement dans la cavité, l'organe conducteur ayant une surface de contact ;
une couche de redistribution, RDL, (28) sous une surface de dessous de l'organe conducteur (22) opposée à la surface de contact ; et
une couche barrière de diffusion (24) disposée entre l'organe conducteur (22) et au moins une portion de la couche de liaison diélectrique (20) et entre l'organe conducteur (22) et la RDL (28), la couche barrière de diffusion (24) comprenant un métal barrière, dans lequel le métal barrière de la couche barrière de diffusion (24) a une propension à l'oxydation qui est supérieure à une propension à l'oxydation de l'organe conducteur (22).

2. L'élément de la revendication 1, dans lequel le métal barrière a une diffusivité avec la couche de liaison diélectrique (20) supérieure à une diffusivité de tantale ou de nitrure de tantale avec la couche de liaison diélectrique (20).

3. L'élément de la revendication 1, dans lequel une épaisseur du métal barrière est comprise dans une plage allant de 1 nm à 100 nm.

4. L'élément de la revendication 1, dans lequel la surface (20a) de la couche de liaison diélectrique (20) comprend une surface de liaison (32) qui est configurée pour se lier directement à une couche diélectrique (20') d'un autre élément, et la surface de contact de l'organe conducteur (22) est configurée pour se lier directement à un plot de contact (22') de l'autre élément.

5. L'élément de la revendication 1, dans lequel la couche barrière de diffusion (24) comprend un matériau qui se diffuse dans la couche de liaison diélectrique (20) en réponse à un processus de recuit.

6. L'élément de la revendication 1, dans lequel la couche de liaison diélectrique (20) comprend de l'oxyde de silicium, la couche barrière de diffusion (24) comprend un composé barrière incluant le métal barrière et un matériau de la couche de liaison diélectrique (20), et le composé barrière comprend du silicate de manganèse ou un composé de manganèse.

7. L'élément de la revendication 1, dans lequel une portion de la couche barrière de diffusion (24) est en outre disposée sur la surface (20a) de la couche de liaison diélectrique (20), et la portion de la couche barrière de diffusion (24) est configurée pour se lier à une couche diélectrique (20') d'un autre élément.

8. L'élément (2, 3, 5, 5') de la revendication 1, comprenant en outre une couche barrière (26) au moins partiellement entre la couche barrière de diffusion (24) et l'organe conducteur (22).

9. L'élément (5, 5') de la revendication 8, dans lequel la couche barrière (26) n'est pas disposée sur une surface de dessous de la cavité (21), et la couche barrière (26) est disposée partiellement le long de parois latérales de la cavité (21) depuis la surface (20a) de la couche de liaison diélectrique (20).

10. L'élément (2, 3) de la revendication 8, dans lequel la couche barrière (26) est disposée de telle sorte que la couche barrière sépare complètement l'organe conducteur (22) et la couche barrière de diffusion (24).

11. L'élément de la revendication 8, dans lequel la couche barrière (26) comprend du nitrure de tungstène, du nitrure de tantale ou du nitrure de titane.

12. L'élément de la revendication 1, dans lequel le métal barrière est configuré pour former un alliage avec l'organe conducteur (22).

13. L'élément de la revendication 1, dans lequel la couche barrière de diffusion (24) comprend un matériau de silicate métallique incluant le métal barrière, et l'élément étant configuré pour être directement lié de manière hybride à un deuxième élément.

14. L'élément de n'importe lesquelles des revendications précédentes, dans lequel le métal barrière comprend du manganèse, du nickel, ou du titane.
